# EUROPEAN PATENT APPLICATION

(11) **EP 4 807 039 A1**
(43) Date of publication of application: **16.09.2026**
(21) Application number: 24888758.0
(22) Date of filing: 07.11.2024
(51) Int. Cl.: C23C 14/04, H10K 59/10, H10K 71/16

(54) **MASK AND METHOD FOR PRODUCING MASK**

(30) Priority: 07.11.2023 JP 2023189939
(71) Applicant: Dai Nippon Printing Co., Ltd., Tokyo 162-8001 (JP)
(72) Inventor: HASHIMOTO, Katsumi, Tokyo 162-8001 (JP); OZAWA, Yutaka, Tokyo 162-8001 (JP)
(74) Representative: Müller-Boré & Partner Patentanwälte PartG mbB
(86) International application number: PCT/JP2024/039547
(87) International publication number: WO 2025/100465

(57) **Abstract**

A mask may include: a first layer including a first surface and a second surface located opposite the first surface and having at least one first opening extending through the first layer; a second layer including a third surface facing the first surface and a fourth surface located opposite the third surface and having a second opening extending through the second layer at a position overlapping the first opening in plan view; and a third layer including a fifth surface facing the second opening and/or the fourth surface and a sixth surface located opposite the fifth surface and having multiple third openings extending through the third layer at positions overlapping the first opening and the second opening in plan view. The second layer may contain silicon oxide, silicon nitride, or silicon oxynitride. The third layer may contain silicon or metal.

## Description

### Technical Field

Embodiments of the present disclosure relate to masks and mask manufacturing methods.

### Background Art

A vapor deposition method is known as a method for forming a precise pattern. In the vapor deposition method, a mask that has an opening is combined with a substrate. Subsequently, a vapor deposition material is adhered to the substrate via the opening in the mask. With the vapor deposition method, a vapor deposition layer that contains the vapor deposition material is formed on the substrate in a pattern that corresponds to the pattern of the opening in the mask. For example, the vapor deposition method is used as a method for forming pixels of an organic EL display device.

For example, Patent Literature 1 discloses a vapor deposition mask that includes an outer frame substrate including beams defining multiple pixel areas, and that also includes a mask substrate including multiple openings located in the pixel areas. The mask substrate is thinner than the outer frame substrate. For example, the mask substrate has a thickness ranging between 1 µm and 100 µm, and the outer frame substrate has a thickness ranging between 100 µm and 775 µm.

### Citation List

### Patent Literature

PTL 1: Japanese Unexamined Patent Application Publication No. 2022-175723

### Summary of Invention

### Technical Problem

It is desirable to control the shape, size, or position of each opening formed in the mask substrate with high precision.

### Solution to Problem

A mask according to an embodiment of the present disclosure may include: a first layer including a first surface and a second surface located opposite the first surface, the first layer having at least one first opening extending through the first layer from the first surface to the second surface; a second layer including a third surface facing the first surface and a fourth surface located opposite the third surface, the second layer having at least one second opening at a position overlapping the first opening in plan view, the at least one second opening extending through the second layer from the third surface to the fourth surface; and a third layer including a fifth surface facing the second opening and/or the fourth surface and a sixth surface located opposite the fifth surface, the third layer having a plurality of third openings at positions overlapping the first opening and the second opening in plan view, the plurality of third openings extending through the third layer from the fifth surface to the sixth surface. The second layer may contain silicon oxide, silicon nitride, or silicon oxynitride. The third layer may contain silicon or metal.

### Advantageous Effects of Invention

According to the embodiment of the present disclosure, the shape, size, or position of each opening can be controlled with high precision.

### Brief Description of Drawings

[Fig. 1] Fig. 1 is a cross-sectional view illustrating an example of an organic device.
[Fig. 2] Fig. 2 illustrates an example of a vapor deposition apparatus including a mask.
[Fig. 3] Fig. 3 is a plan view illustrating an example of the mask as viewed from an entrance surface.
[Fig. 4] Fig. 4 is a plan view illustrating an example of the mask as viewed from an exit surface.
[Fig. 5] Fig. 5 is a cross-sectional view of the mask taken along line V-V in Fig. 3.
[Fig. 6] Fig. 6 is a cross-sectional view illustrating an example of a pattern region.
[Fig. 7] Fig. 7 is a cross-sectional view illustrating an example of a mask manufacturing method according to an embodiment.
[Fig. 8] Fig. 8 is a cross-sectional view illustrating the example of the mask manufacturing method according to the embodiment.
[Fig. 9] Fig. 9 is a cross-sectional view illustrating the example of the mask manufacturing method according to the embodiment.
[Fig. 10] Fig. 10 is a cross-sectional view illustrating the example of the mask manufacturing method according to the embodiment.
[Fig. 11] Fig. 11 is a cross-sectional view illustrating the example of the mask manufacturing method according to the embodiment.
[Fig. 12] Fig. 12 is a cross-sectional view illustrating the example of the mask manufacturing method according to the embodiment.
[Fig. 13] Fig. 13 is a cross-sectional view illustrating the example of the mask manufacturing method according to the embodiment.
[Fig. 14] Fig. 14 illustrates an example of the overall configuration of a dry etching device.
[Fig. 15] Fig. 15 is an enlarged cross-sectional view of a protrusion of a first coating layer.
[Fig. 16] Fig. 16 corresponds to Fig. 15 and is for explaining a modification of the embodiment.
[Fig. 17] Fig. 17 illustrates an example of an apparatus including the organic device.

### Description of Embodiments

In the present description and the drawings, terms, such as a "substrate", a "sheet", and a "film", implying a substance on which a structure is based are not distinguished from each other only based on different names, unless otherwise specifically noted.

In the present description and the drawings, for example, terms, such as "parallel" and "perpendicular", and the values of a length and an angle that specify shapes, geometrical conditions, and the degrees thereof are not limited to strict meanings but are interpreted to an extent that similar functions may be expected, unless otherwise specifically noted.

In the present description and the drawings, in a case where a certain component, such as a member or a region, is "on" or "under", "on an upper side of" or "on a lower side of", or "above" or "below" another component, such as another member or another region, such a case includes a case where the component is directly in contact with the other component, unless otherwise specifically noted. The aforementioned case also includes a case where another component is included between the component and the other component, that is, a case where the component and the other component are indirectly in contact with each other. As for the terms "on", "upper side", and "above", or "under", "lower side", and "below", an up-down direction may be inverted, unless otherwise specifically noted.

In the present description, if there are multiple upper limit candidates and multiple lower limit candidates that are related to a certain parameter, a numerical range for the parameter may be a combination of one arbitrarily selected upper limit candidate and one arbitrarily selected lower limit candidate. A conceivable example is a case where "For example, a parameter B is A1 or more, may be A2 or more, or may be A3 or more. For example, the parameter B is A4 or less, may be A5 or less, or may be A6 or less". In this case, the numerical range for the parameter B may be A1 or more and A4 or less, A1 or more and A5 or less, A1 or more and A6 or less, A2 or more and A4 or less, A2 or more and A5 or less, A2 or more and A6 or less, A3 or more and A4 or less, A3 or more and A5 or less, or A3 or more and A6 or less.

In the present description and the drawings, a state where a surface of an element A "faces" a surface of an element B includes not only a case where the surface of the element A is in contact with the surface of the element B but also a case where an element C is located between the surface of the element A and the surface of the element B, unless otherwise specifically noted. Specifically, the term "face" represents the orientations of two surfaces.

In the present description and the drawings, identical sections or sections with similar functions are designated by the same reference sign or similar reference signs, unless otherwise specifically noted, and redundant descriptions thereof are sometimes omitted. For the sake of convenience, the dimensional ratios in the drawings may sometimes differ from actual ratios, and some components may sometimes be omitted from the drawings.

In the present description and the drawings, an embodiment in the present description may be combined with another example so long as contractions do not occur, unless otherwise specifically noted. Moreover, other examples may be combined with each other so long as contractions do not occur.

In the present description and the drawings, if two or more steps or processes related to a method, such as a manufacturing method, are disclosed, another undisclosed step or process may be performed between the disclosed steps or processes, unless otherwise specifically noted. The order of the disclosed steps or processes is arbitrary so long as contractions do not occur.

An embodiment in the present description relates to an example where a mask is used to form an organic layer or an electrode on a substrate when an organic EL display device is manufactured. However, the use of the mask is not particularly limited, and the present embodiment may be applied to masks that are used for various purposes. For example, the mask according to the present embodiment may be used to form an electrode of a device for displaying or projecting an image or a video image for expressing virtual reality, that is, so-called VR, or augmented reality, that is, so-called AR. In addition, the mask according to the present embodiment may be used for forming an electrode of a display device other than an organic EL display device, such as an electrode of a liquid-crystal display device. Moreover, the mask according to the present embodiment may be used for forming an electrode of an organic device other than a display device, such as an electrode of a pressure sensor.

A first aspect of the present disclosure provides a mask including:
a first layer including a first surface and a second surface located opposite the first surface, the first layer having at least one first opening extending through the first layer from the first surface to the second surface;
a second layer including a third surface facing the first surface and a fourth surface located opposite the third surface, the second layer having at least one second opening at a position overlapping the first opening in plan view, the at least one second opening extending through the second layer from the third surface to the fourth surface; and
a third layer including a fifth surface facing the second opening and/or the fourth surface and a sixth surface located opposite the fifth surface, the third layer having a plurality of third openings at positions overlapping the first opening and the second opening in plan view, the plurality of third openings extending through the third layer from the fifth surface to the sixth surface.

The second layer contains silicon oxide, silicon nitride, or silicon oxynitride.

The third layer contains silicon or metal.

A second aspect of the present disclosure may include the following aspect in the mask according to the first aspect described above. The third layer may include a pattern region and a surrounding region, the pattern region overlapping the first opening and the second opening in plan view, the surrounding region surrounding the pattern region in plan view. The second layer may be located between the surrounding region and the first layer.

A third aspect of the present disclosure may include the following aspect in the mask according to the first or second aspect described above. The third layer may contain monocrystalline silicon.

A fourth aspect of the present disclosure may include the following aspect in the mask according to any one of the first to third aspects described above. The third layer may be an epitaxial layer.

A fifth aspect of the present disclosure may include the following aspect in the mask according to any one of the first to fourth aspects described above. The second layer may contain silicon dioxide.

A sixth aspect of the present disclosure may include the following aspect in the mask according to any one of the first to fifth aspects described above. The first layer may contain silicon or a silicon compound.

A seventh aspect of the present disclosure provides a mask manufacturing method for manufacturing the mask according to any one of the first to sixth aspects described above, the mask manufacturing method including:
a step for forming a multilayer body including the first layer and a first coating layer that covers the second surface of the first layer;
a step for forming an uneven surface corresponding to a shape of the third layer on a surface of the first coating layer;
a step for forming the third layer on the uneven surface, the third layer accommodating a protrusion of the first coating layer within each third opening;
a step for forming the first opening by removing a portion of the first layer; and
a step for forming the second layer having the second opening from the first coating layer by removing a portion of the first coating layer, the removed portion of the first coating layer being the first coating layer within the third opening.

An eighth aspect of the present disclosure may include the following aspect in the mask manufacturing method according to the seventh aspect described above. The step for forming the third layer on the uneven surface may include a step for forming a second coating layer that covers a protrusion of the uneven surface, and a step for forming the third layer having the third opening from the second coating layer by polishing a surface of the second coating layer until the protrusion of the first coating layer becomes exposed.

A ninth aspect of the present disclosure may include the following aspect in the mask manufacturing method according to the seventh or eighth aspect described above. The third layer may contain monocrystalline silicon. The step for forming the third layer on the uneven surface may include a step for causing the monocrystalline silicon to epitaxially grow on the uneven surface.

A tenth aspect of the present disclosure may include the following aspect in the mask manufacturing method according to the seventh or eighth aspect described above. The third layer may contain metal. The step for forming the third layer on the uneven surface may include a step for performing sputtering, vapor deposition, ion plating, and/or plating on the uneven surface.

An eleventh aspect of the present disclosure may include the following aspect in the mask manufacturing method according to any one of the seventh to tenth aspects described above. The first layer may contain silicon or a silicon compound. The step for forming the multilayer body including the first layer and the first coating layer may include a step for preparing a substrate composed of a material identical to a material of the first layer, and a step for setting one portion of the substrate as the first layer and oxidizing or thermally oxidizing another portion of the substrate to form the first coating layer from said another portion.

A twelfth aspect of the present disclosure may include the following aspect in the mask manufacturing method according to any one of the seventh to tenth aspects described above. The step for forming the multilayer body including the first layer and the first coating layer may include a step for depositing a material for forming the first coating layer onto the second surface of the first layer.

An embodiment of the present disclosure will now be described in detail with reference to the drawings. The embodiment to be described below is an example of an embodiment of the present disclosure, and the present disclosure is not to be interpreted limitedly to this embodiment.

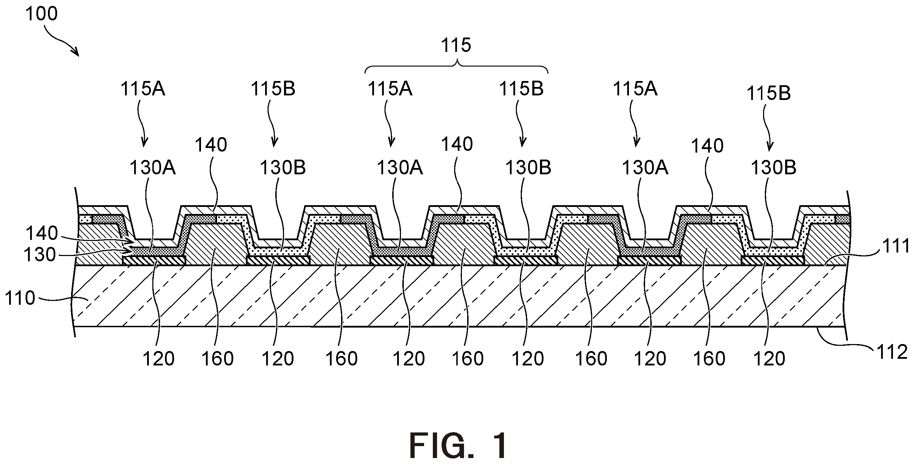

An organic device 100 including an organic layer formed by using a mask will now be described. The organic device 100 includes an organic layer or an electrode formed by using a mask. Fig. 1 is a cross-sectional view illustrating an example of the organic device 100.

The organic device 100 includes a substrate 110 and multiple elements 115 arranged in an in-plane direction of the substrate 110. The substrate 110 includes a first surface 111 and a second surface 112 located opposite the first surface 111. The elements 115 are located on the first surface 111. The elements 115 are, for example, pixels. The substrate 110 may include two or more types of elements 115. For example, the substrate 110 may include first elements 115A and second elements 115B. Although not illustrated, the substrate 110 may include third elements. The first elements 115A, the second elements 115B, and the third elements are, for example, red pixels, blue pixels, and green pixels.

The elements 115 may include first electrodes 120, organic layers 130 that are located on the first electrodes 120, and second electrodes 140 that are located on the organic layers 130.

The organic device 100 may include insulation layers 160 each of which is located between two of the first electrodes 120 adjacent to each other in plan view. For example, the insulation layers 160 contain polyimide. The insulation layers 160 may overlap ends of the first electrodes 120. The expression "in plan view" means that an object is viewed in the normal direction of a surface of a plate member, such as the substrate 110.

The substrate 110 may be an insulating member. The material used as the substrate 110 may be, for example, a member having low flexibility, such as silicon, quartz glass, Pyrex (registered trademark) glass, or a synthetic quartz plate, or a member having flexibility, such as a resin film, an optical resin plate, or thin glass. The substrate 110 may have a planar shape similar to that of a silicon wafer used in manufacturing semiconductor. In this case, the substrate 110 can be processed by using a device that performs a semiconductor manufacturing step. For example, the first electrodes 120 and the insulation layers 160 can be formed on the substrate 110 by using the device that performs the semiconductor manufacturing step.

The elements 115 are configured to achieve a certain function as a result of voltage being applied between the first electrodes 120 and the second electrodes 140 or electric current flowing between the first electrodes 120 and the second electrodes 140. For example, if the elements 115 are pixels of an organic EL display device, the elements 115 are capable of releasing light for forming a video image.

The first electrodes 120 contain a conductive material. For example, the first electrodes 120 contain metal, a conductive metal oxide, or another conductive inorganic material. The first electrodes 120 may contain a transparent conductive metal oxide, such as an indium tin oxide.

The organic layers 130 contain an organic material. When the organic layers 130 are supplied with electricity, the organic layers 130 can exhibit a certain function. The expression "supplied with electricity" means that voltage is applied to the organic layers 130 or electric current flows to the organic layers 130. The organic layers 130 used may be, for example, light-emitting layers that release light when supplied with electricity or layers with an optical transmittance or a refractive index that changes when supplied with electricity. The organic layers 130 may contain an organic semiconductor material.

As illustrated in Fig. 1, the organic layers 130 may include first organic layers 130A and second organic layers 130B. The first organic layers 130A are included in the first elements 115A. The second organic layers 130B are included in the second elements 115B. Although not illustrated, the organic layers 130 may include third organic layers that are included in the third elements. For example, the first organic layers 130A, the second organic layers 130B, and the third organic layers are red light-emitting layers, blue light-emitting layers, and green light-emitting layers.

When voltage is applied between the first electrodes 120 and the second electrodes 140, the organic layers 130 that are located therebetween are driven. If the organic layers 130 are light-emitting layers, light is released from the organic layers 130, and the light is extracted from the second electrodes 140 or the first electrodes 120 to the outside.

The organic layers 130 may further include, for example, a hole injection layer, a hole transport layer, an electron transport layer, and an electron injection layer.

The second electrodes 140 may contain a conductive material, such as metal. Examples of the material that can be used as the second electrodes 140 may include platinum, gold, silver, copper, iron, tin, chromium, aluminum, indium, lithium, sodium, potassium, calcium, magnesium, carbon, and an alloy thereof. As illustrated in Fig. 1, the second electrodes 140 may extend across two of the organic layers 130 adjacent to each other in plan view.

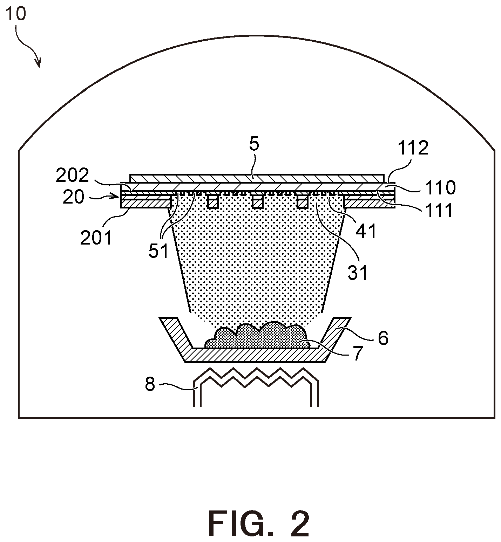

A method for forming the organic layers 130 on the substrate 110 by vapor deposition will now be described. Fig. 2 illustrates a vapor deposition apparatus 10. The vapor deposition apparatus 10 performs a vapor deposition process involving depositing a vapor deposition material on an object.

As illustrated in Fig. 2, the vapor deposition apparatus 10 may include therein a vapor deposition source 6, a heater 8, and a mask 20. The vapor deposition apparatus 10 may further include exhaust means for creating a vacuum atmosphere in the vapor deposition apparatus 10. The vapor deposition source 6 is, for example, a crucible. The vapor deposition source 6 contains a vapor deposition material 7, such as an organic material or a metallic material. The heater 8 heats the vapor deposition source 6 to vaporize the vapor deposition material 7 in the vacuum atmosphere.

The mask 20 has an entrance surface 201, an exit surface 202, first openings 31, second openings 41, and third openings 51. The entrance surface 201 faces the vapor deposition source 6. The exit surface 202 is located opposite the entrance surface 201. The exit surface 202 faces the first surface 111 of the substrate 110. The first openings 31 are located in the entrance surface 201. The third openings 51 are located in the exit surface 202. The first openings 31 and the third openings 51 are connected in the thickness direction of the mask 20 via the second openings 41. One second opening 41 overlaps one first opening 31 in plan view. Multiple third openings 51 overlap one second opening 41 and one first opening 31 in plan view. A portion of the vapor deposition material 7 entering the mask 20 via the entrance surface 201exits the exit surface 202 by passing through the first openings 31, the second openings 41, and the third openings 51. The vapor deposition material 7 exiting the exit surface 202 adheres to the first surface 111 of the substrate 110. The exit surface 202 of the mask 20 may be in contact with the first surface 111 of the substrate 110.

As illustrated in FIG. 2, the vapor deposition apparatus 10 may include a magnet 5 disposed on the second surface 112 of the substrate 110. If the mask 20 contains a magnetic material, the magnet 5 can attract the mask 20 toward the substrate 110 by using a magnetic force. This enables a gap to be reduced or eliminated between the mask 20 and the substrate 110. Accordingly, an occurrence of a shadow during a vapor deposition step can be suppressed. In the present application, a shadow is a phenomenon where the thickness of the organic layers 130 near the wall surfaces of the third openings 51 is smaller than the thickness of the organic layers 130 at the centers of the third openings 51. A shadow occurs due to, for example, adhesion of the vapor deposition material 7 to a wall surface of the mask 20 or entry of the vapor deposition material 7 into a gap between the mask 20 and the substrate 110.

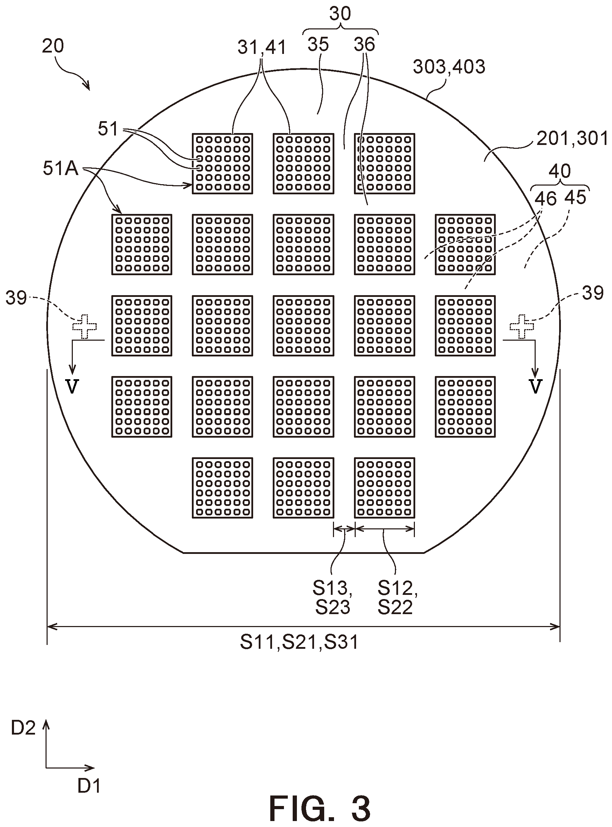

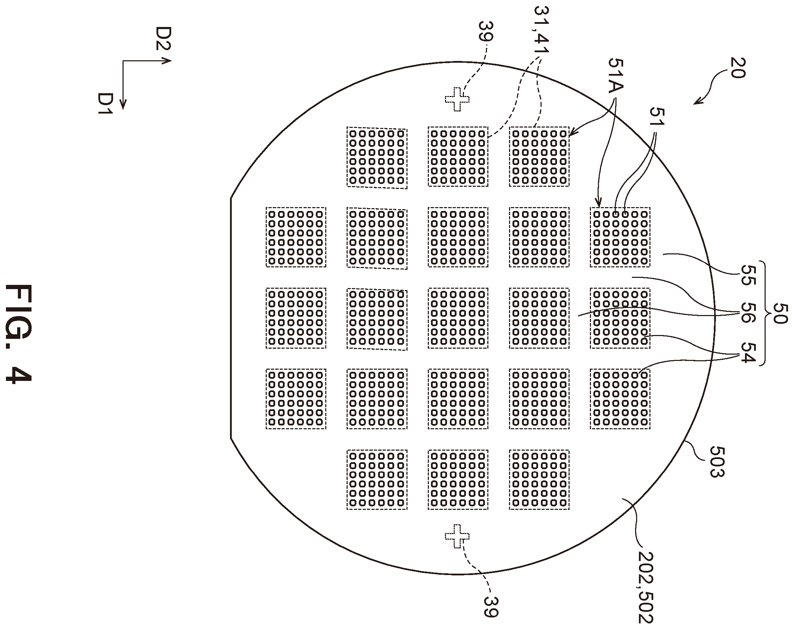

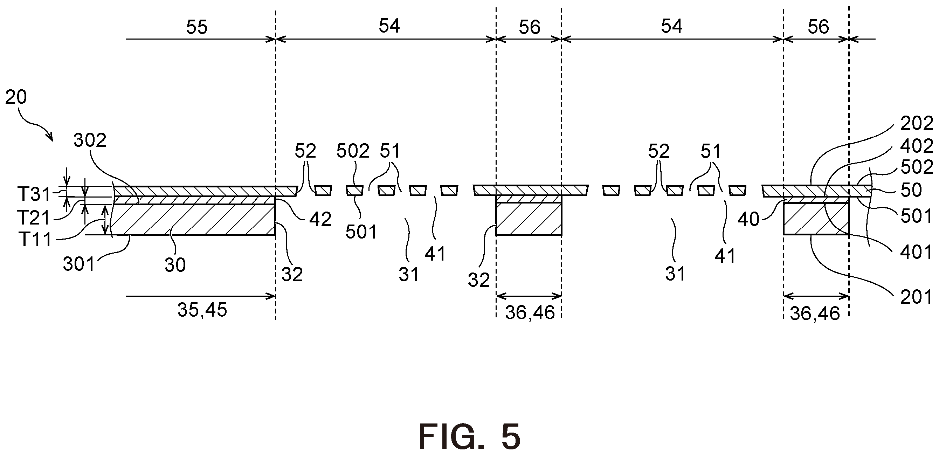

The mask 20 will now be described in detail. Fig. 3 is a plan view illustrating an example of the mask 20 as viewed from the entrance surface 201. Fig. 4 is a plan view illustrating an example of the mask 20 as viewed from the exit surface 202. Fig. 5 is a cross-sectional view of the mask 20 taken along line V-V in Fig. 3.

As illustrated in Fig. 5, the mask 20 includes a first layer 30, a second layer 40, and a third layer 50.

The first layer 30 includes a first surface 301, a second surface 302, the first openings 31, and first wall surfaces 32. The first surface 301 may form the entrance surface 201. The second surface 302 is located opposite the first surface 301 in the thickness direction of the first layer 30.

The first openings 31 extend through the first layer 30 from the first surface 301 to the second surface 302. As illustrated in Fig. 3, the first layer 30 may include multiple first openings 31. The multiple first openings 31 may be arranged in a first direction D1 and a second direction D2. The second direction D2 may be orthogonal to the first direction D1. The first direction D1 and the second direction D2 are parallel to the first surface 301.

One first opening 31 may correspond to one screen of the organic EL display device. The mask 20 including the multiple first openings 31 can form patterns of organic layers corresponding to multiple screens simultaneously on the substrate 110. As illustrated in Fig. 3, each first opening 31 may have a rectangular contour in plan view.

The first wall surfaces 32 are located between the first surface 301 and the second surface 302. Each first wall surface 32 faces the corresponding first opening 31. In the example illustrated in Fig. 5, the first wall surfaces 32 extend in the normal direction of the first surface 301.

As illustrated in Fig. 3, a region of the first layer 30 where the first openings 31 are not provided may be segmented into an outer region 35 and an inner region 36. The inner region 36 is located between two of the first openings 31 adjacent to each other in plan view. The outer region 35 is located between an outer edge 303 of the first layer 30 and the first openings 31 in plan view. As illustrated in Fig. 3, the inner region 36 may extend in the first direction D1 and the second direction D2.

As illustrated in Fig. 3 and Fig. 4, the first layer 30 may include alignment marks 39. For example, the alignment marks 39 are provided on the second surface 302. The alignment marks 39 may be provided on the first surface 301. For example, the alignment marks 39 are used for adjusting the relative position of the substrate 110 with respect to the mask 20. If the substrate 110 has properties that enable visible light to pass therethrough, the alignment marks 39 can be visually recognized through the substrate 110.

As illustrated in Fig. 3 and Fig. 4, the alignment marks 39 may have a cross-shaped contour in plan view. Although not illustrated, the alignment marks 39 may have a contour with a shape other than a cross shape, such as a rectangular shape or a circular shape. The alignment marks 39 may be located in the outer region 35 or may be located in the inner region 36.

The alignment marks 39 may have any shape in cross section. For example, each alignment mark 39 may include a recess located in the first surface 301 or the second surface 302. Each alignment mark 39 may include a hole extending through the first layer 30 from the first surface 301 to the second surface 302. The recesses and the holes may be formed by etching the first surface 301 or the second surface 302. The recesses and the holes may be formed by irradiating the first surface 301 or the second surface 302 with laser light. For example, each alignment mark 39 may include a layer located on the first surface 301 or the second surface 302. The layer is composed of a material different from that of the first layer 30. The alignment marks 39 may be formed in a layer other than the first layer 30.

The first layer 30 contains silicon or a silicon compound. For example, the first layer 30 is fabricated by processing a silicon wafer. As illustrated in Fig. 3, the outer edge 303 of the first layer 30 may include a straight section. The straight section is also referred to as an orientation flat. Although not illustrated, the outer edge 303 may have a cutout. This cutout is also referred to as a notch. The orientation flat and the notch represent the crystal orientation of the silicon wafer.

For example, a maximum dimension S11 of the first layer 30 in plan view is 100 mm or more, may be 150 mm or more, or may be 200 mm or more. For example, the dimension S11 is 500 mm or less, may be 400 mm or less, or may be 300 mm or less.

For example, a dimension S12 of each first opening 31 in the direction in which the first openings 31 are arranged is 5 mm or more, may be 10 mm or more, or may be 20 mm or more. For example, the dimension S12 is 100 mm or less, may be 50 mm or less, or may be 30 mm or less.

For example, a distance S13 between two of the first openings 31 in the direction in which the first openings 31 are arranged is 0.1 mm or more, may be 0.5 mm or more, or may be 1.0 mm or more. For example, the distance S13 is 20 mm or less, may be 15 mm or less, or may be 10 mm or less.

The thickness of the first layer 30 is defined as a maximum thickness T11 of the outer region 35. For example, the thickness T11 is 50 µm or more, may be 100 µm or more, or may be 200 µm or more. For example, the thickness T11 is 1000 µm or less, may be 800 µm or less, or may be 600 µm or less.

The second layer 40 will now be described. As illustrated in Fig. 5, the second layer 40 includes a third surface 401, a fourth surface 402, the second openings 41, and second wall surfaces 42. The third surface 401 faces the second surface 302 of the first layer 30. The fourth surface 402 is located opposite the third surface 401 in the thickness direction of the second layer 40.

The second openings 41 extend through the second layer 40 from the third surface 401 to the fourth surface 402. As illustrated in Fig. 3, the second layer 40 may include multiple second openings 41. Similar to the multiple first openings 31, the multiple second openings 41 may be arranged in the first direction D1 and the second direction D2. The second openings 41 overlap the first openings 31 in plan view. One second opening 41 may overlap one first opening 31.

The second wall surfaces 42 are located between the third surface 401 and the fourth surface 402. Each second wall surface 42 faces the corresponding second opening 41. In the example illustrated in Fig. 5, the second wall surfaces 42 extend in the normal direction of the third surface 401.

As illustrated in Fig. 3, a region of the second layer 40 where the second openings 41 are not provided may be segmented into an outer region 45 and an inner region 46. The inner region 46 is located between two of the second openings 41 adjacent to each other in plan view. The outer region 45 is located between an outer edge 403 of the second layer 40 and the second openings 41 in plan view. As illustrated in Fig. 3, the inner region 46 may extend in the first direction D1 and the second direction D2. The outer region 45 overlaps the outer region 35 of the first layer 30 in plan view. The inner region 46 overlaps the inner region 36 of the first layer 30 in plan view.

The second layer 40 may contain silicon oxide SiOx. The second layer 40 may contain silicon dioxide. The second layer 40 is fabricated by processing a coating layer (i.e., a first coating layer 65 to be described later) provided on the second surface 302 of the first layer 30. The coating layer 65 may be formed by performing an oxidation treatment, a thermal oxidation treatment, or the like partially on a silicon wafer serving as a substrate 60 for forming the first layer 30 mentioned above.

A maximum dimension S21 of the second layer 40 in plan view may be the same as the dimension S11. A dimension S22 of each second opening 41 in the direction in which the second openings 41 are arranged may be the same as the dimension S12. A distance S23 between two of the second openings 41 in the direction in which the second openings 41 are arranged may be the same as the distance S13.

The thickness of the second layer 40 is defined as a maximum thickness T21 between the first layer 30 and the third layer 50. The thickness T21 is smaller than the thickness T11 of the first layer 30. For example, the thickness T21 is 25.0 µm or less, may be 10.0 µm or less, or may be 5.0 µm or less. For example, the thickness T21 is 0.5 µm or more, may be 1.0 µm or more, or may be 2.0 µm or more.

The third layer 50 will now be described. As illustrated in Fig. 5, the third layer 50 includes a fifth surface 501 and a sixth surface 502. The fifth surface 501 faces the fourth surface 402 and/or the second openings 41 of the second layer 40. The sixth surface 502 is located opposite the fifth surface 501 in the thickness direction of the third layer 50. The sixth surface 502 may form the exit surface 202 or a part thereof.

The third layer 50 contains silicon. The third layer 50 may contain monocrystalline silicon. The third layer 50 may be fabricated by, for example, causing a monocrystalline silicon layer to epitaxially grow on the second layer 40. The monocrystalline silicon layer may be formed on the second layer 40 by performing chemical vapor deposition, metal-organic chemical vapor deposition, or molecular beam epitaxy.

The third layer 50 includes multiple through-hole groups 51A. Each through-hole group 51A includes multiple third openings 51. The multiple through-hole groups 51A included are arranged along the fifth surface 501. For example, similar to the multiple first openings 31 and second openings 41, the multiple through-hole groups 51A may be arranged in the first direction D1 and the second direction D2. The through-hole groups 51A overlap the first openings 31 and the second openings 41 in plan view. One through-hole group 51A may overlap one first opening 31 and one second opening 41.

Each through-hole group 51A includes multiple third openings 51. The multiple third openings 51 in one through-hole group 51A may overlap one first opening 31 and one second opening 41 in plan view. As illustrated in Fig. 5, each third opening 51 extends through the third layer 50 from the fifth surface 501 to the sixth surface 502.

One third opening 51 corresponds to one vapor deposition layer. One vapor deposition layer is, for example, one organic layer 130. A group of multiple third openings 51 included in one through-hole group 51A may correspond to one screen of the organic EL display device.

As illustrated in Fig. 4 and Fig. 5, the third layer 50 may include pattern regions 54, an outer edge region 55, and a surrounding region 56 in plan view. In other words, the third layer 50 may be segmented into the multiple pattern regions 54, the outer edge region 55, and the surrounding region 56 in plan view. Each pattern region 54 includes multiple third openings 51 that overlap the corresponding first opening 31 and the corresponding second opening 41 in plan view. One pattern region 54 may correspond to one through-hole group 51A. The pattern regions 54 may be defined by the second wall surfaces 42 of the second layer 40 in plan view. The surrounding region 56 surrounds the pattern regions 54 in plan view. One surrounding region 56 may surround the multiple pattern regions 54. The outer edge region 55 surrounds the surrounding region 56 in plan view. The outer edge region 55 may be located at an outer edge 503 of the third layer 50. The outer edge region 55 may extend along the entire circumference of the outer edge 503 of the third layer 50.

As illustrated in Fig. 5, the third layer 50 includes third wall surfaces 52. The third wall surfaces 52 are located between the fifth surface 501 and the sixth surface 502. As illustrated in Fig. 5, each third wall surface 52 faces the corresponding third opening 51.

A maximum dimension S31 of the third layer 50 in plan view may be the same as the dimension S11 and the dimension S21. The dimension S31 may be smaller than the dimension S11 and the dimension S21. In other words, in plan view, the outer edge 503 of the third layer 50 may be located within the outer edge 303 of the first layer 30 and the outer edge 403 of the second layer 40.

The thickness of the third layer 50 is defined as a maximum thickness T31 in each pattern region 54. The thickness T31 is smaller than the thickness T11 of the first layer 30. The thickness T31 of the third layer 50 may be smaller than the thickness T21 of the second layer 40, may be the same as the thickness T21, or may be larger than the thickness T21. For example, the thickness T31 is 25.0 µm or less, may be 10.0 µm or less, or may be 5.0 µm or less. As a result, an occurrence of a shadow can be suppressed. For example, the thickness T31 is 0.5 µm or more, may be 1.0 µm or more, or may be 2.0 µm or more. As a result, an occurrence of, for example, a defect or deformation, such as a pin hole, in the third layer 50 can be suppressed.

The pattern regions 54, the outer edge region 55, and the surrounding region 56 will be described in detail.

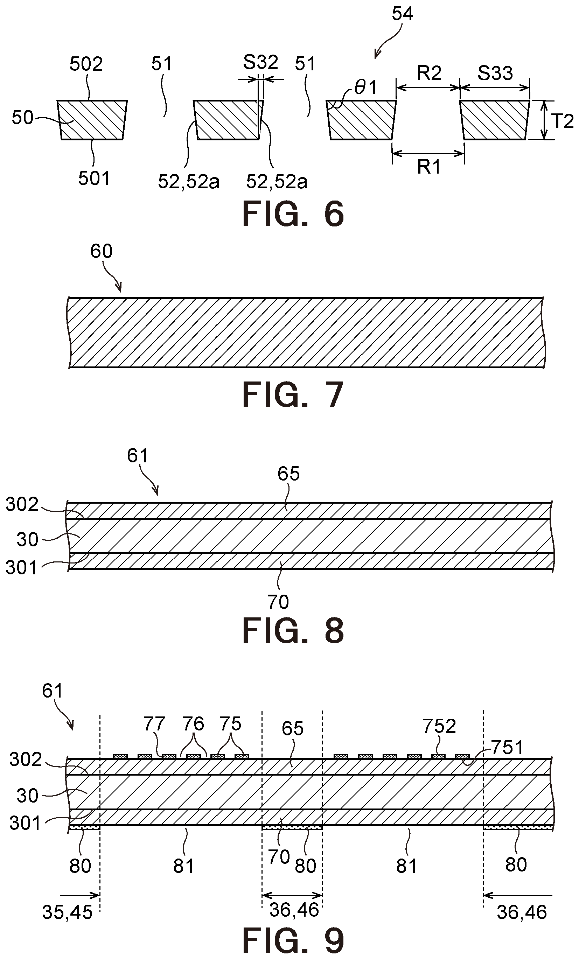

Fig. 6 is a cross-sectional view illustrating an example of one of the pattern regions 54. Reference sign R1 denotes a dimension of each third opening 51 in the fifth surface 501. Reference sign R2 denotes a dimension of each third opening 51 in the sixth surface 502. The dimension R1 is also referred to as a first dimension. The dimension R2 is also referred to as a second dimension. A dimension of a vapor deposition layer to be formed on the substrate 110 in accordance with a vapor deposition step using the mask 20 is determined in accordance with the second dimension R2 of each third opening 51 in the sixth surface 502.

The first dimension R1 may be larger than the second dimension R2. In other words, the second dimension R2 may be smaller than the first dimension R1. As a result, an occurrence of a shadow near each third wall surface 52 can be suppressed. The first dimension R1 and the second dimension R2 are determined in the direction in which the third openings 51 are arranged.

As illustrated in Fig. 6, each third wall surface 52 may include a tapered surface 52a that tapers away from the center of the corresponding third opening 51 from the sixth surface 502 toward the fifth surface 501. With the third wall surface 52 including a tapered surface 52a, the first dimension R1 can be made larger than the second dimension R2.

For example, the second dimension R2 is 1.0 µm or more, may be 2.0 µm or more, or may be 3.0 µm or more. For example, the second dimension R2 is 25.0 µm or less, may be 10.0 µm or less, or may be 5.0 µm or less.

In Fig. 6, reference sign S32 denotes a width of each tapered surface 52a in the direction in which the third openings 51 are arranged. For example, the width S32 is 0.2 µm or more, may be 0.5 µm or more, or may be 1.0 µm or more. For example, the width S32 is 25 µm or less, may be 20 µm or less, or may be 10 µm or less.

In Fig. 6, reference sign θ1 denotes an angle formed between each third wall surface 52 and the sixth surface 502. For example, the angle θ1 is 50° or more, may be 55° or more, or may be 60° or more. For example, the angle θ1 is less than 90°, may be 85° or less, or may be 80° or less.

For example, a distance S33 between two of the third wall surfaces 52 in the direction in which the third openings 51 are arranged is 1.0 µm or more, may be 2.0 µm or more, or may be 3.0 µm or more. For example, the distance S33 is 25.0 µm or less, may be 10.0 µm or less, or may be 5.0 µm or less.

The thicknesses of the respective layers, the dimensions and widths of the components, and so on are measured by observing a cross-sectional image of the mask 20 by using a scanning electron microscope.

A manufacturing method for the mask 20 will now be described. First, as illustrated in Fig. 7, a substrate preparation step for preparing the substrate 60 is performed. The substrate 60 used may be a silicon wafer. One surface and the other surface of the substrate 60 may be polished to a mirror finish. An arithmetic average roughness Ra of each of the one surface and the other surface of the substrate 60 may be 1.5 nm or less, or may be 1.0 nm or less. The plane orientations of the one surface and the other surface of the substrate 60 may be (100), (110), and/or the like.

Subsequently, as illustrated in Fig. 8, a first coating layer 65 is formed entirely over the one surface of the substrate 60. The first coating layer 65 may be a silicon oxide film. Furthermore, as illustrated in Fig. 8, a coating layer 70 may be formed on the other surface of the substrate 60. The coating layer 70 is used as a resist layer in a first layer processing step to be described later, and is thus also referred to as a resist coating layer 70 hereinafter. The resist coating layer 70 may be a silicon oxide film. The coating layers 65 and 70 may each be formed by oxidizing or thermally oxidizing a portion of the substrate 60. In the substrate 60, a portion where the coating layers 65 and 70 are not formed becomes the first layer 30. Accordingly, a multilayer body 61 in which the first layer 30, the first coating layer 65, and the resist coating layer 70 are integrated is fabricated.

The thickness of the first coating layer 65 may be greater than or equal to the sum of the thickness T21 of the second layer 40 and the thickness T31 of the third layer 50. The thickness of the resist coating layer 70 is not particularly limited. The resist coating layer 70 preferably has a sufficient thickness that allows it to function as a resist film in the first layer processing step to be described later.

Subsequently, as illustrated in Fig. 9, a first resist layer 75 is partially formed on the surface of the first coating layer 65. The first resist layer 75 has multiple first resist openings 76. The first resist layer 75 includes a seventh surface 751, an eighth surface 752, the first resist openings 76, and first resist wall surfaces 77. The seventh surface 751 faces the first coating layer 65. The eighth surface 752 is located opposite the seventh surface 751 in the thickness direction of the first resist layer 75. The first resist openings 76 extend through the first resist layer 75 from the seventh surface 751 to the eighth surface 752. The first resist wall surfaces 77 are located between the seventh surface 751 and the eighth surface 752. Each first resist wall surface 77 faces the corresponding first resist opening 76.

The first resist openings 76 are formed in correspondence with the multiple third openings 51 in the third layer 50. The first resist layer 75 may be formed in accordance with a known method. In detail, a resist layer material serving as a material for forming the first resist layer 75 is prepared, and the resist layer material is partially applied over the first coating layer 65. Then, the resist layer material on the first coating layer 65 is exposed to light, and the resist layer material is developed. As a result, the first resist layer 75 having the multiple first resist openings 76 is formed.

Furthermore, as illustrated in Fig. 9, a second resist layer 80 is partially formed on the surface of the resist coating layer 70. The second resist layer 80 has multiple second resist openings 81. The second resist openings 81 are formed in correspondence with the multiple first openings 31 in the first layer 30. The second resist layer 80 may be formed in accordance with the same method as the first resist layer 75.

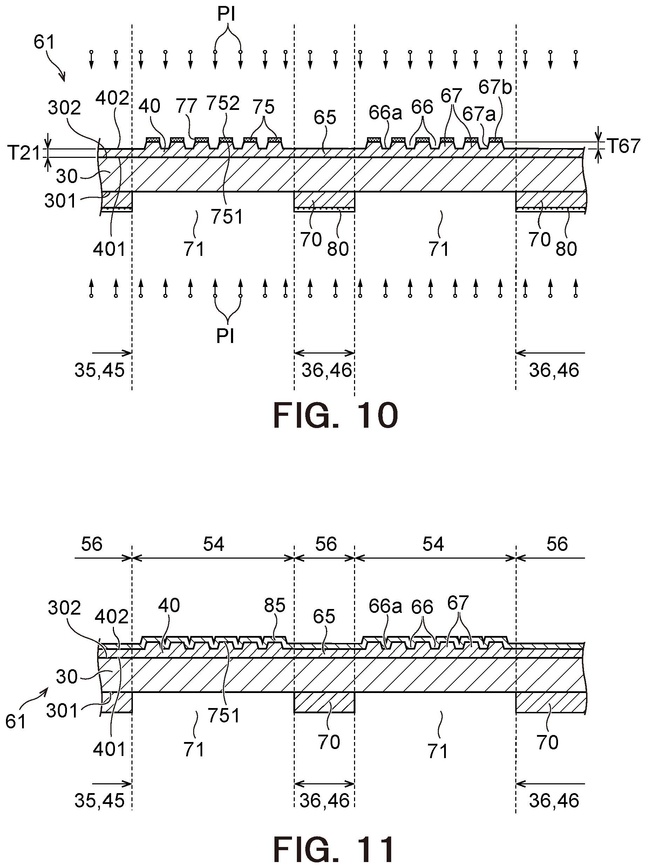

Subsequently, a first dry etching step is performed on the first coating layer 65. Dry etching may be reactive ion etching (RIE). In detail, as illustrated in Fig. 10, the surface of the first coating layer 65 is exposed to an etching gas PI containing plasma-converted process gas. The etching gas PI etches portions of the first coating layer 65 that are not covered by the first resist layer 75. The etching proceeds from the first coating layer 65 toward the first layer 30. Thus, recesses 66 are formed in the surface of the first coating layer 65 at positions corresponding to the first resist openings 76. As a result, the surface of the first coating layer 65 becomes an uneven surface including the recesses 66 and protrusions 67. Each recess 66 has a bottom surface 66a. Each protrusion 67 has a side surface 67a and a top surface 67b. The side surface 67a faces the corresponding recess 66. The top surface 67b faces the opposite side from the first layer 30.

A second dry etching step is performed on the resist coating layer 70. In detail, as shown in Fig. 10, the surface of the resist coating layer 70 is exposed to the etching gas PI containing plasma-converted process gas. The etching gas PI etches portions of the resist coating layer 70 that are not covered by the second resist layer 80. The etching proceeds from the resist coating layer 70 toward the first layer 30. Thus, portions of the resist coating layer 70 that overlap the second resist openings 81 in plan view are removed. As a result, third resist openings 71 are formed in the resist coating layer 70.

The etching using the etching gas PI may be anisotropic etching. Anisotropic etching may be, for example, reactive ion etching. Specifically, a dry etching step may include an anisotropic etching step. In anisotropic etching, the etching reaction proceeds substantially in one direction. For example, the etching proceeds substantially in the thickness direction of the first coating layer 65 and the resist coating layer 70. Thus, the uneven shape of the first coating layer 65 and the shape of the third resist openings 71 in the resist coating layer 70 can be controlled with high precision.

The etching gas PI is not particularly limited so long as the coating layers 65 and 70 can be dry-etched with the etching gas PI. The etching gas PI may be, for example, a gas containing CF₄, CHF₃, or C₄F₈.

The uneven shape of the first coating layer 65 may be a shape that corresponds to the shape of the third layer 50. In more detail, the shape, size, and position of each protrusion 67 of the first coating layer 65 correspond to the shape, size, and position of each third opening 51. A dimension T67 of each protrusion 67 in the thickness direction of the first coating layer 65 may be greater than or equal to the thickness T31 of the third layer 50. The dimension T67 of the protrusion 67 is defined as a distance between the bottom surface 66a of the recess 66 and the top surface 67b of the protrusion 67. Therefore, the dimension T67 is also the dimension of the recess 66 in the thickness direction of the first coating layer 65.

The bottom surface 66a of each recess 66 of the first coating layer 65 defines the fifth surface 501 of the third layer 50. A distance between the bottom surface 66a of the first coating layer 65 and a surface facing the first layer 30 is equal to the thickness T21 of the second layer 40.

Subsequently, the first resist layer 75 is removed from the first coating layer 65. Moreover, the second resist layer 80 is removed from the resist coating layer 70. The first resist layer 75 and the second resist layer 80 can be removed by using, for example, a resist processing solution.

Then, as illustrated in Fig. 11, a second coating layer 85 is formed over the uneven surface of the first coating layer 65. The second coating layer 85 may be an epitaxial layer formed by epitaxial growth. An epitaxial layer is a layer that grows on a monocrystalline substrate. The second coating layer 85 formed by epitaxial growth is also referred to as an epitaxial layer 85. The epitaxial layer 85 may be formed by, for example, a vapor-phase growth method. In detail, the multilayer body 61 is placed within a reaction chamber of a vapor-phase growth device, a vapor-phase-growth gas is introduced into the reaction chamber, and the epitaxial layer 85 is caused to grow over the uneven surface of the first coating layer 65. The epitaxial layer 85 is, for example, a monocrystalline silicon film. The vapor-phase-growth gas includes a reaction gas serving as a raw material for the monocrystalline silicon film, a carrier gas for diluting the reaction gas, etc. The reaction gas is, for example, a silane-based gas, such as trichlorosilane. The carrier gas is, for example, hydrogen. As the reaction proceeds, the recesses 66 of the first coating layer 65 become filled with the epitaxial layer 85. For example, the epitaxial layer 85 may grow until the recesses 66 are completely filled with the epitaxial layer 85.

After the epitaxial layer 85 grows to a desired thickness, the introduction of the vapor-phase-growth gas into the reaction chamber is stopped, thereby causing the epitaxial layer 85 to stop growing.

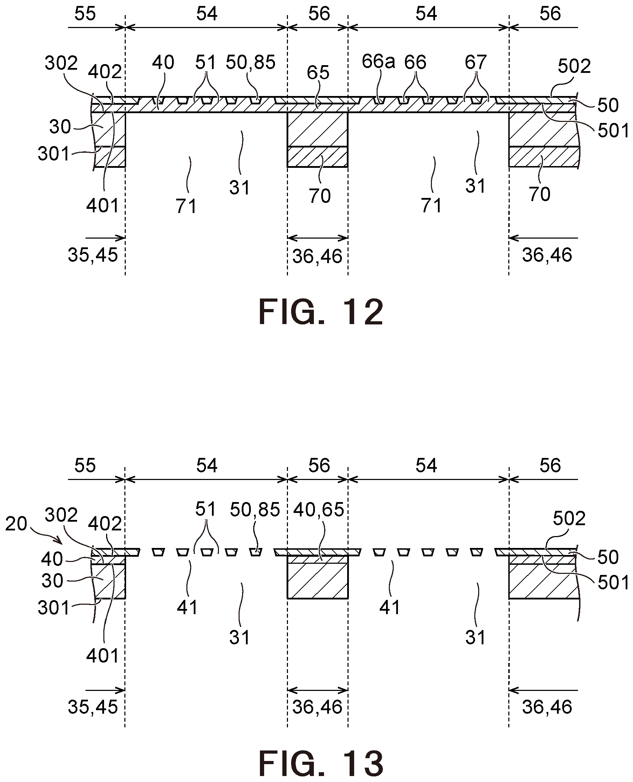

Then, a polishing step is performed. The polishing step involves polishing and flattening the surface of the second coating layer 85, as illustrated in Fig. 12. The polishing step may involve polishing the second coating layer 85 by chemical mechanical polishing. The polishing step may be performed until the polishing surface of a polishing tool reaches the protrusions 67 of the first coating layer 65 in the thickness direction. As a result, the protrusions 67 become exposed on the surface of the second coating layer 85. In other words, through-holes that accommodate the protrusions 67 of the first coating layer 65 are formed in the second coating layer 85. As mentioned above, the shape, size, and position of each protrusion 67 of the first coating layer 65 correspond to the shape, size, and position of each third opening 51. Therefore, the through-holes in the second coating layer 85 become the third openings 51. Accordingly, the third layer 50 having the third openings 51 are fabricated from the second coating layer 85.

Subsequently, a first-layer processing step for forming the first openings 31 in the first layer 30 is performed. As illustrated in Fig. 12, in the first-layer processing step, the first layer 30 is etched from the first surface 301 side of the first layer 30, so that the first openings 31 are formed in the first layer 30. The etching may be dry etching using an etching gas. In this case, the resist coating layer 70 on the first layer 30 may be used as a resist layer. Moreover, the first coating layer 65 may be used as a stopper layer that suppresses progression of the etching to the third layer 50. The etching gas may be, for example, SF₆ gas.

Then, as illustrated in Fig. 13, a first-coating-layer removal step for removing portions of the first coating layer 65 is performed. The first-coating-layer removal step is performed by supplying an etchant for the first coating layer 65 to the first openings 31. According to the first-coating-layer removal step, the first coating layer 65 overlapping the first openings 31 in plan view is removed. As a result, the second layer 40 having the second openings 41 is fabricated from the first coating layer 65. By removing the portions of the first coating layer 65, the first coating layer 65 within the third openings 51 in the third layer 50 is removed. The resist coating layer 70 may also be removed simultaneously with the removal of the first coating layer 65. The removal of the coating layers 65 and 70 may be performed by dry etching using a fluorine-based gas, or may be performed by wet etching using an etching solution containing hydrofluoric acid. Accordingly, the mask 20 is fabricated.

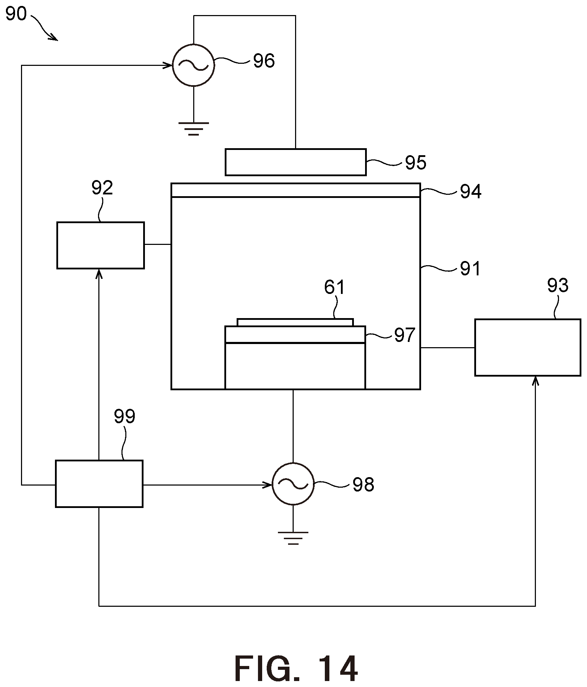

Next, a dry etching device 90 used for performing the first dry etching step or the second dry etching step on the coating layer 65 or 70 will be described. Fig. 14 illustrates an example of the overall configuration of the dry etching device 90. In the example illustrated in Fig. 14, the dry etching device 90 includes a chamber 91, gas supplying means 92, and exhaust means 93. The gas supplying means 92 supplies an etching gas into the chamber 91. The exhaust means 93 exhausts the gas from inside the chamber 91. By supplying the etching gas into the chamber 91 from the gas supplying means 92 while exhausting the gas from the exhaust means 93, pressure adjustment within the chamber 91 is performed.

The dry etching device 90 further includes a dielectric window 94 and an antenna 95. The dielectric window 94 is attached to an upper portion of the chamber 91 and hermetically seals the chamber 91. The antenna 95 is disposed outside the chamber 91, for example, above the dielectric window 94. The antenna 95 may be of a loop coil type. A high-frequency power source 96 is connected to the antenna 95 via a matching circuit (not illustrated). The high-frequency power source 96 functions as a power source that supplies electric power for generating plasma within the chamber.

The dry etching device 90 further includes a stage 97. The stage 97 is disposed within the chamber 91. When the multilayer body 61 is to be etched, the multilayer body 61 is disposed on the stage 97. A bias-application power source 98 is connected to the stage 97 via a matching circuit (not illustrated). The bias-application power source is also referred to as a bias power source.

The dry etching device 90 further includes control means 99. The dry etching device 90 controls the gas supplying means 92, the exhaust means 93, the high-frequency power source 96, and the bias power source 98. Each type of parameter can be adjusted by the control means 99. Examples of parameters adjustable by the control means 99 include a flow rate of the etching gas to be supplied from the gas supplying means 92 to the chamber 91, a flow rate of the gas to be exhausted from the chamber 91 by the exhaust means 93, the pressure within the chamber 91, an output from the high-frequency power source 96, an output from the bias power source 98, a voltage to be applied to the antenna 95, and a voltage to be applied to the stage 97. The voltage to be applied to the antenna 95 is also referred to as an antenna voltage. The voltage to be applied to the stage 97 is also referred to as a bias voltage.

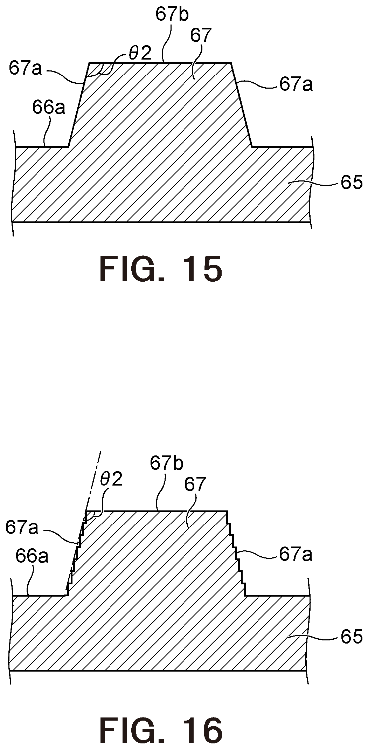

As mentioned above, the recesses 66 and the protrusions 67 of the first coating layer 65 are formed in conformity to the shape of the third layer 50. The shape of the side surface 67a of each protrusion 67 determines the shape of the third wall surface 52 of the corresponding third opening 51. Thus, an angle θ2 (see Fig. 15) between the side surface 67a and the top surface 67b of the protrusion 67 determines the angle θ1 formed between the third wall surface 52 and the sixth surface 502.

For example, the angle between the side surface 67a and a top surface 67b of the protrusion 67 may be controlled in accordance with the following method:
- control the angle of the first resist wall surface 77 relative to the eighth surface 752 of the first resist layer 75;
- control the aforementioned parameters of the dry etching device 90;
- select an etching gas to be supplied from the gas supplying means 92 to the chamber 91;
- adjust a resist selection ratio; and
- adjust the thickness of the first coating layer 65.

The order indicated in the above method has no relation to the order of control. For example, the adjustment of the thickness of the first coating layer 65 may be performed prior to the selection of the etching gas to be supplied from the gas supplying means 92 to the chamber 91.

According to the knowledge obtained by the inventor, the thickness of deposition occurring on an etched side surface can be adjusted by controlling the bias voltage applied to the stage 97 to regulate the balance between ions and radicals in the plasma, whereby the progression of unintended side etching can be suppressed.

Furthermore, according to the knowledge obtained by the inventor, the angle θ2 between the side surface 67a and the top surface 67b of the protrusion 67 increases when the flow rate of the etching gas supplied from the gas supplying means 92 to the chamber 91 is increased. However, in this case, the etching rate and the resist selection ratio deteriorate.

Furthermore, according to the knowledge obtained by the inventor, the angle θ2 between the side surface 67a and the top surface 67b of the protrusion 67 increases when the antenna voltage is reduced. In this case, the etching rate and the resist selection ratio hardly change.

Furthermore, according to the knowledge obtained by the inventor, the angle θ2 between the side surface 67a and the top surface 67b of the protrusion 67 increases when the bias voltage is reduced. In this case, the etching rate and the resist selection ratio deteriorate significantly.

In the manufacturing method for the mask 20 according to the above-described embodiment, the first coating layer 65 is used as a mold for forming the third layer 50. Because the uneven shape of the first coating layer 65 can be controlled with high precision, the shape, size, or position of the third layer 50 can be controlled with high precision. In particular, the shape, size, or position of each third opening 51 can be controlled with high precision.

The above-described embodiment can be modified in various ways. Modifications will now be described with reference to the drawings, where necessary. In the following description and the drawings used for the following description, sections that may be similar to those in the above-described embodiment are given the same reference signs as the reference signs used for the corresponding sections in the above-described embodiment. Redundant descriptions will be omitted. If the effects obtained in the above-described embodiment are obviously obtained also in the modifications, the descriptions thereof may sometimes be omitted.

### (First Modification)

The coating layers 65 and 70 may be formed by depositing the material for forming the coating layers 65 and 70 onto the substrate 60. In this case, the substrate 60 constitutes the first layer 30. In this case, the first coating layer 65 and the resist coating layer 70 may be formed by low-pressure chemical vapor deposition (low-pressure CVD) or plasma-enhanced chemical vapor deposition (plasma-enhanced CVD). For example, the first coating layer 65 containing silicon oxide SiOx may be formed by low-pressure chemical vapor deposition or plasma-enhanced chemical vapor deposition using tetraethyl orthosilicate Si(OC₂H₅)₄ as a raw material. Tetraethyl orthosilicate Si(OC₂H₅)₄ is also referred to as "TEOS (tetraethoxysilane)". For example, the first coating layer 65 containing silicon oxide SiOx may be formed by plasma-enhanced chemical vapor deposition using silane SiH₄ and nitrogen oxide N₂O as raw materials. With low-pressure chemical vapor deposition, the first coating layer 65 and the resist coating layer 70 can be formed simultaneously on multiple substrates 60. With plasma-enhanced chemical vapor deposition, the first coating layer 65 and the resist coating layer 70 can be formed on the substrate 60 at a lower temperature, as compared with low-pressure chemical vapor deposition.

### (Second Modification)

The second layer 40 may contain silicon nitride SiₓN_{y} or silicon oxynitride SiOₓN_{y}. In this case, the first coating layer 65 may be a silicon nitride film or a silicon oxynitride film. The silicon nitride film or the silicon oxynitride film may be formed by performing low-pressure chemical vapor deposition, plasma-enhanced chemical vapor deposition, sputtering, or the like on a silicon wafer serving as the first layer 30. For example, the first coating layer 65 containing silicon nitride may be formed by low-pressure chemical vapor deposition or plasma-enhanced chemical vapor deposition using silane SiH₄ and/or nitrogen oxide N₂O and/or ammonia NH₃ as a raw material or raw materials.

### (Third Modification)

The side surface 67a of each protrusion 67 of the second layer 40 may be formed into a stepped shape. In this case, the third wall surface 52 of the corresponding third opening 51 in the third layer 50 is also formed into a stepped shape, but this conceivably does not pose practical issues. The protrusion 67 having the stepped side surface 67a can be formed by repeating the formation of the first resist layer 75 and the etching of the first coating layer 65 multiple times. In this case, the area of the first resist layer 75 and the etching depth of the first coating layer 65 are controlled every time, so that a gradient θ2 of the side surface 67a relative to the top surface 67b of the protrusion 67 can be controlled.

### (Fourth Modification)

The third layer 50 may contain metal. The metal may be a magnetic material or a nonmagnetic material. Examples of the magnetic material include nickel, iron, cobalt, and an alloy thereof. Examples of the nonmagnetic material include copper, aluminum, titanium, chromium, and an alloy thereof. The third layer 50 may be constituted of a single layer or may be constituted of multiple layers.

In the case where the third layer 50 contains metal, the third layer 50 may be formed by physical deposition, plating, or a combination thereof. The physical deposition may be sputtering, vapor deposition, or ion plating. The plating may be electrolytic plating or electroless plating. The third layer 50 may include a layer formed by physical deposition and a layer formed by plating. In this case, the layer formed by physical deposition may form the fifth surface 501 of the third layer. In this case, the layer formed by physical deposition may function as a seed layer for the layer formed by plating. Specifically, after a layer is formed by physical deposition on the uneven surface of the first coating layer 65, this layer may be used as a seed layer to form a layer by plating.

### (Fifth Modification)

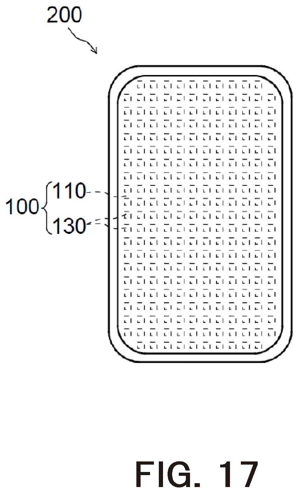

Fig. 17 illustrates an example of an apparatus 200 including the organic device 100. The apparatus 200 includes the substrate 110 and the organic layers 130. The organic layers 130 are formed by vapor deposition using the mask 20. An example of the apparatus 200 is a smartphone. The apparatus 200 may be, for example, a tablet terminal or a wearable terminal. Examples of the wearable terminal include smart glasses and a head-mounted display.

Multiple components disclosed in the above embodiment and modifications can be appropriately combined, where necessary. Alternatively, some of the components may be removed from all of the components indicated in the above embodiment and modifications.

## Claims

1. A mask comprising:
a first layer including a first surface and a second surface located opposite the first surface, the first layer having at least one first opening extending through the first layer from the first surface to the second surface;
a second layer including a third surface facing the first surface and a fourth surface located opposite the third surface, the second layer having at least one second opening at a position overlapping the first opening in plan view, the at least one second opening extending through the second layer from the third surface to the fourth surface; and
a third layer including a fifth surface facing the second opening and/or the fourth surface and a sixth surface located opposite the fifth surface, the third layer having a plurality of third openings at positions overlapping the first opening and the second opening in plan view, the plurality of third openings extending through the third layer from the fifth surface to the sixth surface,
wherein the second layer contains silicon oxide, silicon nitride, or silicon oxynitride, and
wherein the third layer contains silicon or metal.

2. The mask according to claim 1,
wherein the third layer includes a pattern region and a surrounding region, the pattern region overlapping the first opening and the second opening in plan view, the surrounding region surrounding the pattern region in plan view, and
wherein the second layer is located between the surrounding region and the first layer.

3. The mask according to claim 1, wherein the third layer contains monocrystalline silicon.

4. The mask according to claim 1, wherein the third layer is an epitaxial layer.

5. The mask according to claim 1, wherein the second layer contains silicon dioxide.

6. The mask according to claim 1, wherein the first layer contains silicon or a silicon compound.

7. A mask manufacturing method for manufacturing the mask according to claim 1, the mask manufacturing method comprising:
a step for forming a multilayer body including the first layer and a first coating layer that covers the second surface of the first layer;
a step for forming an uneven surface corresponding to a shape of the third layer on a surface of the first coating layer;
a step for forming the third layer on the uneven surface, the third layer accommodating a protrusion of the first coating layer within each third opening;
a step for forming the first opening by removing a portion of the first layer; and
a step for forming the second layer having the second opening from the first coating layer by removing a portion of the first coating layer, the removed portion of the first coating layer being the first coating layer within the third opening.

8. The mask manufacturing method according to claim 7, wherein the step for forming the third layer on the uneven surface includes a step for forming a second coating layer that covers a protrusion of the uneven surface, and a step for forming the third layer having the third opening from the second coating layer by polishing a surface of the second coating layer until the protrusion of the first coating layer becomes exposed.

9. The mask manufacturing method according to claim 7,
wherein the third layer contains monocrystalline silicon, and
wherein the step for forming the third layer on the uneven surface includes a step for causing the monocrystalline silicon to epitaxially grow on the uneven surface.

10. The mask manufacturing method according to claim 7,
wherein the third layer contains metal, and
wherein the step for forming the third layer on the uneven surface includes a step for performing sputtering, vapor deposition, ion plating, and/or plating on the uneven surface.

11. The mask manufacturing method according to claim 7,
wherein the first layer contains silicon or a silicon compound, and
wherein the step for forming the multilayer body including the first layer and the first coating layer includes a step for preparing a substrate composed of a material identical to a material of the first layer, and a step for setting one portion of the substrate as the first layer and oxidizing or thermally oxidizing another portion of the substrate to form the first coating layer from said another portion.

12. The mask manufacturing method according to claim 7, wherein the step for forming the multilayer body including the first layer and the first coating layer includes a step for depositing a material for forming the first coating layer onto the second surface of the first layer.
